# EUROPÄISCHE PATENTSCHRIFT

(11) **EP 1 982 198 B1**
(45) Veröffentlichungstag und Bekanntmachung des Hinweises auf die Patenterteilung: **17.06.2009**
(21) Anmeldenummer: 07702635.9
(22) Anmeldetag: 09.01.2007
(51) Int. Cl.: G01R 1/067, G01R 31/28

(54) **PRÜFSYSTEM FÜR EINEN SCHALTUNGSTRÄGER**
TEST SYSTEM FOR A CIRCUIT CARRIER
SYSTÈME DE CONTRÔLE POUR PORTE-CIRCUIT

(30) Priorität: 09.02.2006 DE 102006006082; 09.05.2006 DE 102006021569
(43) Veröffentlichungstag der Anmeldung: 22.10.2008
(73) Patentinhaber: Rohde & Schwarz GmbH & Co. KG, 81671 München (DE)
(72) Erfinder: KÖPPL. Josef, 94239 Zachenberg (DE)
(74) Vertreter: Körfer, Thomas
(86) Internationale Anmeldenummer: PCT/EP2007/000127
(87) Internationale Veröffentlichungsnummer: WO 2007/090490

(56) Entgegenhaltungen:
- DE-A1- 10 208 693
- JP-A- 8 015 348
- US-A- 5 506 515
- US-A1- 2005 194 981

## Beschreibung

Die Erfindung bezieht sich auf ein Prüfsystem zur Analyse eines mit einer Hochfrequenzstruktur bestückten Schaltungsträgers.

Bei einem Schaltungsträger für Hochfrequenzanwendungen, welcher für die Bestückung mit bedrahteten Bauelementen und/oder SMD-Bauelementen vorgesehen ist, ist es vorwiegend aus Kostengründen üblich, eine Schaltungsträgerprüfung durchzuführen, um den Schaltungsträger bereits vor der Bestückung mit den Bauelementen nach material- und funktionsspezifischen Fehlern zu untersuchen und für den Fall, dass der Schaltungsträger fehlerbehaftet ist, diesen aus der Produktionskette herauszunehmen.

Mit einem gewöhnlichen Prüfsystem werden Verbindungen auf dem Schaltungsträger anhand einer Durchgangsmessung auf Kurzschlüsse sowie auf Leerläufe überprüft. Ein derartiges Prüfsystem mit der Bezeichnung "Polar" ist von der Firma Polar Instruments bekannt, welches zum Testen von Schaltungsträgern verwendbar und zur Kurzschluss-Fehlersuche sowie zur Impedanzanalyse am zu testenden Schaltungsträger einsetzbar ist. Im Wege der Impedanzanalyse arbeitet das Prüfsystem der Firma Polar Instruments mittels Spannungs-Zeitreflektometrie im unteren Hochfrequenzbereich bis zu einer maximalen Frequenz von etwa 300 MHz. Das Prüfsystem ist schon aufgrund der vergleichsweise niedrigen Maximalfrequenz zum Test von Schaltungsträgern für Hochfrequenzanwendungen, welche im Frequenzbereich bis zu 40 GHz betreibbar sind, ungeeignet. Des weiteren ist das Messverfahren der Spannungs-Zeitreflektometrie mit dem Prüfsystem "Polar" nicht zur Ermittlung von Transmissions- und Reflexionsparametern einer auf dem Schaltungsträger angeordneten Hochfrequenzstruktur einsetzbar, woraus zahlreiche material- und funktionsspezifische Parameter des Messobjekts ableitbar wären.

DE 102 08 693 A1 (ROHDE & SCHWARZ) offenbart eine Vorrichtung zur Prüfung eines mit einer Hochfrequenzstrukur bestückten scheltungsträgers.

Der Erfindung liegt die Aufgabe zu Grunde, ein Prüfsystem anzugeben, womit materialspezifische und funktionsspezifische Hochfrequenzeigenschaften sowie die Funktionstüchtigkeit eines mit einer Hochfrequenzstruktur bestückten Schaltungsträgers über einen besonders großen Frequenzbereich analysierbar sind.

Diese Aufgabe wird erfindungsgemäß gelöst durch die Merkmale des Anspruchs 1. Vorteilhafte Weiterbildungen sind Gegenstand der hierauf bezogenen Unteransprüche.

So umfasst das Prüfsystem zur Analyse eines mit einer Hochfrequenzstruktur bestückten Schaltungsträgers einen Netzwerkanalysator und eine Kontakteinrichtung. Der Netzwerkanalysator weist einen Signalgenerator zur Erzeugung eines Anregungssignals auf, welches über eine Signalleitung der Hochfrequenzstruktur am Schaltungsträger zuführbar ist. Weiter umfasst der Netzwerkanalysator eine Auswerteeinrichtung, welcher ein von der Hochfrequenzstruktur rücklaufendes Messsignal zur Analyse und zum Vergleich mit dem Anregungssignal zuführbar ist. Das Anregungssignal und das rücklaufendes Messsignal sind über die Signalleitung und die an diese anschließbare Kontakteinrichtung in die Hochfrequenzstruktur einspeisbar.

Zur Einspeisung des Anregungssignals und zur Ausspeisung des rücklaufenden Messsignals ist die Kontakteinrichtung vorzugsweise mit einer Messspitze ausgestattet, woran Prüfnadeln befestigt sind, womit ein direkter Kontakt zwischen der Hochfrequenzstruktur und der Kontakteinrichtung herstellbar ist. Dazu kontaktieren die Prüfnadeln am Schaltungsträger angeordnete, zur Einspeisung des Anregungssignals sowie zur Ausspeisung des Messsignals vorgesehene Prüfstellen, welche mit der Hochfrequenzstruktur des Schaltungsträgers signalverbindbar sind.

Unter der Hochfrequenzstruktur ist insbesondere eine auf dem Schaltungsträger ausgebildete Streifenleitung, also beispielsweise ein Hochfrequenzfilter, zu verstehen.

Die mit der Erfindung erzielten Vorteile bestehen insbesondere darin, dass mit dem erfindungsgemäßen, den Netzwerkanalysator umfassenden Prüfsystem der mit der Hochfrequenzstruktur bestückte Schaltungsträger über einen vergleichsweise großen Frequenzbereich bis zu mehreren Gigahertz analysierbar ist. Des weiteren ist anhand des über eine Kontakteinrichtung an die Hochfrequenzstruktur des Schaltungsträgers anschließbaren Netzwerkanalysators zusätzlich zur Ermittlung von Transmissions- und Reflexionsparametern eine vollständige Systemanalyse der Hochfrequenzstruktur durchführbar. Ferner lässt die Analyse der Hochfrequenzstruktur des Schaltungsträgers auch eine Bestimmung des Schaltungsträgermaterials und dessen dielektrischer Eigenschaften sowie eine Untersuchung der in der Hochfrequenzstruktur auftretenden Signallaufzeiten über den vorgegebenen Frequenzbereich zu.

Zudem ist mit dem erfindungsgemäßen Prüfsystem eine besonders stark reduzierte Anzahl von fehlerbehafteten und fertigmontierten, d.h. mit bedrahteten und SMD-Bauelementen bestückten, Schaltungsträgern erreichbar. Durch das Aussortieren fehlerbehafteter, noch nicht mit bedrahteten und SMD-Bauelementen bestückter Schaltungsträger sind die Herstellungskosten jedes einzelnen fertigmontierten und fehlerfreien Schaltungsträgers um ein Vielfaches reduzierbar, da der Produktionsprozess bei fehlerbehafteten Schaltungsträgern bereits vor der kostenintensiven Bestückung mit bedrahteten und SMD-Bauelementen gestoppt wird.

Um eine besonders exakte Analyse des mit der Hochfrequenzstruktur bestückten Schaltungsträgers durchzuführen, ist es zweckmäßig, zwischen die Hochfrequenzstruktur und einer umliegenden auf dem Schaltungsträger angeordneten Schaltungsstruktur einen oder mehrere überbrückbare Leerstreifen vorzusehen. Der bzw. die Leerstreifen ist bzw. sind optional Bestandteil des Schaltungsträgermaterials. Damit ist die Hochfrequenzstruktur zur Analyse von der umliegenden Schaltungsstruktur elektrisch isoliert. Die Analyse der Hochfrequenzstruktur ist somit störungsfrei durchführbar. Nach Durchführung der Analyse ist bzw. sind der bzw. die Leerstreifen anhand einer Brücke überbrückbar, um eine elektrisch leitende Verbindung zwischen der Hochfrequenzstruktur und der umliegenden Schaltungsstruktur des Schaltungsträgers herzustellen und um den Schaltungsträger anwendungsspezifisch nutzen zu können.

Gemäß einer vorteilhaften Ausgestaltung ist die zur Analyse des Schaltungsträgers vorgesehene Hochfrequenzstruktur an einem mit dem Schaltungsträger verbundenen Nutzenrand angeordnet, welcher optional nach Durchführung der Analyse und/oder Fertigstellung des Schaltungsträgers entfernbar ist. Die am Nutzrand angeordnete Hochfrequenzstruktur dient insbesondere auch dazu, die Hochfrequenzeigenschaften des Schaltungsträgermaterials sowie, bei einem mehrschichtigen Schaltungsträger, den Einfluss der einzelnen Trägerschichten auf die Hochfrequenzstruktur zu analysieren.

In zweckmäßiger Weiterbildung ist der Schaltungsträger in einer Halte- und Positioniereinrichtung gelagert, um den Schaltungsträger zu fixieren und die Prüfstelle des Schaltungsträgers den Prüfnadeln der Messspitze anzunähern. Zusätzlich ist die Kontakteinrichtung an der Halte- und Positioniereinrichtung fixierbar, um die an der Messspitze angeordneten Prüfnadeln zur Kontaktierung der Prüfstelle an diese heran zu bewegen.

Gemäß einer vorteilhaften Ausgestaltung sind die an der Messspitze angeordneten Prüfnadeln derart ausgebildet, dass zur Kontaktierung eines an der Prüfstelle vorgesehenen Masseplättchens zumindest eine Masseprüfnadel und zur Kontaktierung eines an der Prüfstelle vorgesehenen Signalplättchens eine Signalprüfnadel, wodurch das Anregungssignal in die Hochfrequenzstruktur einspeisbar ist, vorgesehen sind.

Zweckmäßigerweise ist zwischen einer Kontaktfläche des Signalplättchens, welche die Koppelstelle der Signalprüfnadel und des Signalplättchens darstellt, und einer Kontaktfläche des Masseplättchens ein Abstand von etwa 500 - 1500 Mikrometer vorgesehen.

Um die an ein und desselben Messspitze angeordneten Prüfnadeln voneinander elektrisch zu isolieren, ist es weiter zweckmäßig, die Prüfnadeln jeweils einzeln mit einer Schutzummantelung zu versehen. Dabei ist die Schutzummantelung an der jeweiligen Prüfnadel derart ausgebildet, dass die Prüfnadel an der Koppelstelle zur Kontaktierung der Prüfstelle mantelfrei ist.

Gemäß einer vorteilhaften Ausgestaltung sind für das Prüfsystem Kalibrierstrukturen vorgesehen, womit parasitäre Störeinflüsse eliminierbar sind, welche an Stecker- oder Adapterübergängen sowie an den Koppelstellen der Prüfnadeln entstehen können.

In zweckmäßiger Weiterbildung ist der Schaltungsträger aus einem Material mit dielektrischen Eigenschaften hergestellt, welches sich zur Anwendung für den Hochfrequenzbereich besonders eignet. Zu den Materialien zählen insbesondere Polytetrafluorethylen, Polyimide sowie Glas- und Keramiklegierungen.

Eine mehrschichtige Ausführung des Schaltungsträgers ist dahingehend zweckmäßig, dass eine vergleichsweise große Anzahl von Hochfrequenzstrukturen, beispielsweise Hochfrequenzfilter, als Streifenleitungen auf dem Schaltungsträger realisierbar sind. Zudem ist die mehrschichtige Ausführung eine platzsparende Variante, weshalb eine auf dem Schaltungsträger zur Verbindung der elektronischen Bauelemente vorgesehene Leitungsstruktur besonders einfache realisierbar ist.

Gemäß einer vorteilhaften Ausgestaltung ist der Schaltungsträger zur Bestückung mit bedrahteten Bauelementen derart ausgebildet, dass zur Fixierung der bedrahteten Bauelemente auf dem Schaltungsträger sowie zur elektrischen Verbindung der bedrahteten Bauelemente mit auf dem Schaltungsträger vorgesehenen Verbindungsleitungen am Schaltungsträger Durchgangsbohrungen vorgesehen sind, welche zwischen gegenüberliegenden Seitenflächen des Schaltungsträgers ausgebildet sind. Im weiteren ist der Schaltungsträger zur Bestückung mit oberflächenmontierbaren SMD-Bauelementen derart ausgebildet, dass auf den Oberflächen des Schaltungsträgers Kontaktflächen einerseits zur Fixierung und andererseits zur elektrischen Kontaktierung der SMD-Bauelemente mit am Schaltungsträger vorgesehenen Verbindungsleitungen angeordnet sind.

Gemäß einer vorteilhaften Ausgestaltung ist der am Netzwerkanalysator vorgesehene Signalgenerator zur Erzeugung des Anregungssignals derart steuerbar, um das Anregungssignal über einen Frequenzbereich, welcher vorgebbar ist, zu durchfahren (Frequenz-Sweep). Der Frequenz-Sweep dient einer besonders umfassenden Analyse des Schaltungsträgers über den vorgebbaren Frequenzbereich mit besonders exakter Frequenzauflösung.

Gemäß einer vorteilhaften Ausgestaltung ist das Anregungssignal am Netzwerkanalysator auskoppelbar und zur Analyse des Schaltungsträgers als Referenzsignal mit dem rücklaufenden Messsignal vergleichbar.

Nachfolgend wird ein Ausführungsbeispiel anhand einer Zeichnung erläutert. Darin zeigen:
- Fig. 1: ein Prinzipschaltbild eines Prüfsystems, woran ein mit einer Hochfrequenzstruktur bestückter Schaltungsträger angeschlossen ist,
- Fig. 2: einen schematischen Aufbau des Prüfsystems gemäß Fig. 1,
- Fig. 3: Kontakteinrichtungen gemäß Fig. 2 mit Messspitzen und Prüfnadeln, welche am Schaltungsträger angeordnete Prüfstellen kontaktieren,
- Fig. 4: eine Messspitze mit Prüfnadeln gemäß Fig. 3,
- Fig. 5A,5B,5C: jeweils eine Messspitze mit Prüfnadeln gemäß Fig. 3 und
- Fig. 6: eine Prüfstelle gemäß Fig. 3.

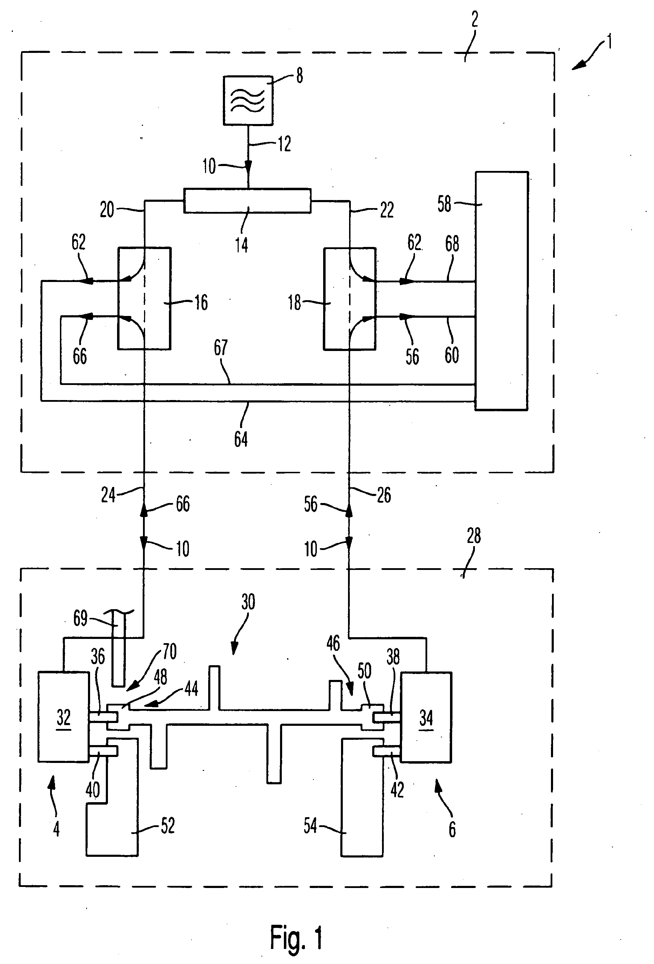

Fig. 1 zeigt ein Prinzipschaltbild des Prüfsystems 1 mit einem Netzwerkanalysator 2 sowie mit einer ersten Kontakteinrichtung 4 und einer zweiten Kontakteinrichtung 6. Der Netzwerkanalysator 2 umfasst einen Signalgenerator 8 zur Erzeugung des Anregungssignals 10, welches über eine Signalleitung 12 einer Schalteinrichtung 14 zuführbar ist. Der Netzwerkanalysator 2 umfasst weiterhin eine erste Messbrücke 16 und eine zweite Messbrücke 18, welche mit der Schalteinrichtung 14 über Signalleitungen 20,22 signalverbunden sind.

Die Kontakteinrichtungen 4,6 sind über Signalleitungen 24,26 mit dem Netzwerkanalysator 2 signalverbunden. Das Anregungssignal 10 ist den Kontakteinrichtungen 4,6 über die Signalleitungen 24,26 zuführbar. Um das Anregungssignal 10 in eine auf dem Schaltungsträger 28 vorgesehene Hochfrequenzstruktur 30, welche im in Fig. 1 gezeigten Ausführungsbeispiel als Frequenzfilter in Streifenleitungstechnik ausgeführt ist, einzuspeisen, umfassen die Kontakteinrichtungen 4,6 jeweils eine Messspitze 32,34 und jeweils als Signalprüfnadeln 36,38 sowie als Masseprüfnadeln 40,42 ausgebildete Kontaktstifte. Zur Einspeisung des Anregungssignals 10 kontaktieren die Signalprüfnadeln 36,38 an auf dem Schaltungsträger 28 vorgesehenen Prüfstellen 44,46 angeordnete Signalplättchen 48,50. Die Masseprüfnadeln 40,42 kontaktieren an den Prüfstellen 44,46 vorgesehene Masseplättchen 52,54.

Zur Analyse des mit der Hochfrequenzstruktur 30 bestückten Schaltungsträgers 28 mit dem Prüfsystem 1 wird die Schalteinrichtung 14 veranlasst, das Anregungssignal 10 der ersten Kontakteinrichtung 4 über die Signalleitung 20 und die Signalleitung 24 oder der zweiten Kontakteinrichtung 6 über die Signalleitung 22 und die Signalleitung 26 zuzuführen. Die Hochfrequenzstruktur 30 ist auch als Messobjekt betrachtbar, wobei das Anregungssignal 10 zur Analyse des Messobjekts entweder über die als Eingangstor dienende Prüfstelle 44 oder über die als Ausgangstor dienende Prüfstelle 46 diesem zugeführt wird.

Mit dem Netzwerkanalysator 2 werden beispielsweise s-Parameter ermittelt. Zur Ermittlung des s-Parameters "Vorwärtsübertragungsfaktor s₂₁", welcher das Verhältnis einer durch das Messobjekt transmittierten und am Ausgangstor des Messobjekts rücklaufenden Welle b₂ zu einer am Eingangstor einfallenden Welle a₁ des Anregungssignals beschreibt, wird das Anregungssignal 10 an der Prüfstelle 44 der Hochfrequenzstruktur 30 zugeführt. Ein durch die Hochfrequenzstruktur 30 transmittiertes und auf der Signalleitung 26 rücklaufendes Messsignal 56 wird an der zweiten Messbrücke 18 zur Auswertung auf eine zu einer Auswerteeinrichtung 58 führenden Signalleitung 60 ausgekoppelt. Der "Vorwärtsübertragungsfaktor s₂₁" wird somit aus dem rücklaufenden Messsignal 56 und dem Anregungssignal 10, welches als Referenzsignal 62 auf eine zu der Auswerteeinrichtung 58 führenden Signalleitung 64 ausgekoppelt wird, ermittelt.

Zur Bestimmung des s-Parameters "Rückwärtsübertragungsfaktor s₁₂" wird das Anregungssignal 10 der Hochfrequenzstruktur 30 über die zweite Kontakteinrichtung 6 zugeführt. Ein durch die Hochfrequenzstruktur 30 zum Eingangstor transmittiertes, an der ersten Kontakteinrichtung 4 ausgespeistes und auf der Signalleitung 24 rücklaufendes Messsignal 66 wird an der ersten Messbrücke 16 auf eine zu der Auswerteeinrichtung 58 führenden Signalleitung 67 ausgekoppelt. Das der Auswerteeinrichtung 58 zugeführte Messsignal 66 wird darauffolgend mit dem an der zweiten Messbrücke 18 ausgekoppelten und über eine Signalleitung 68 der Auswerteeinrichtung 58 zugeführten Referenzsignal 62 zur Ermittlung des "Rückwärtsübertragungsfaktor s₁₂" verglichen.

Aus der Ermittlung der s-Parameter sind Eigenschaften der Hochfrequenzstrukturen auf dem Schaltungsträger über einen gewünschten Frequenzbereich wie beispielsweise Transmissions- und Reflexionsdämpfung, Signallaufzeiten, Signalanstiegszeiten, Impedanzverläufe, Sprungantworten sowie Phaseninformationen ableitbar. Zudem sind Parameter des Schaltungsträgers wie beispielsweise dessen Material, die dielektrischen Eigenschaften des Materials sowie - bei mehrschichtigen Schaltungsträgern - die Qualität deren Schichtaufbaus bestimmbar.

Um die Analyse an der Hochfrequenzstruktur 30 weitgehend störfrei von umliegender Schaltungsstruktur 69, welche in Fig. 1 lediglich durch eine abgeschnittene Streifenleitung angedeutet ist, durchzuführen, ist die Hochfrequenzstruktur 30 anhand eines oder mehrere überbrückbarer Leerstreifen 70 von der umliegenden Schaltungsstruktur 69 elektrisch isolierbar.

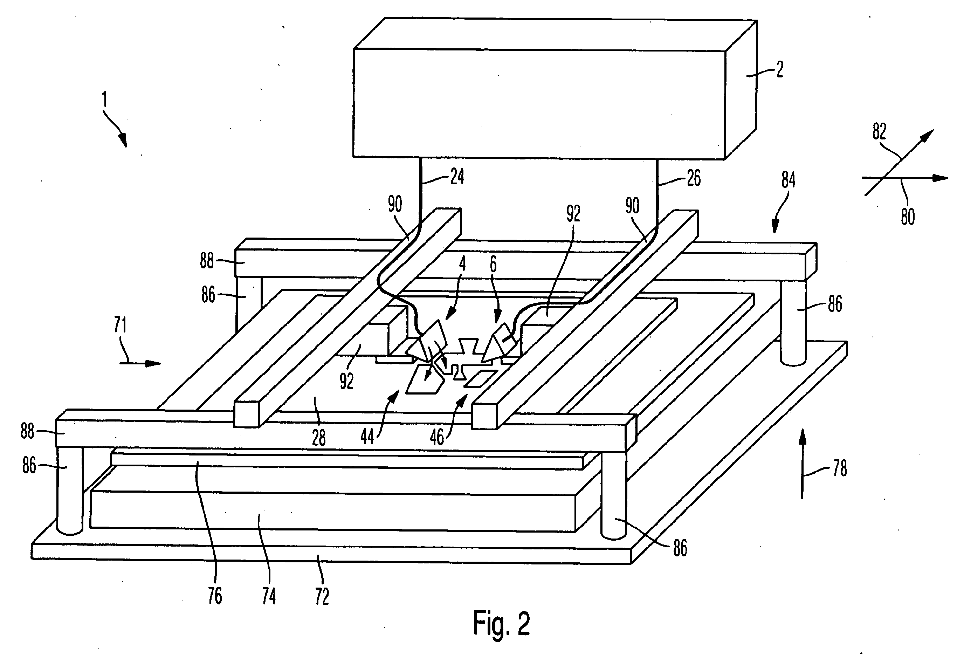

Fig. 2 zeigt einen schematischen Aufbau des Prüfsystems 1, wobei der Schaltungsträger 28 in einer Halte- und Positioniereinrichtung 71 gelagert ist. Die Halte- und Positioniereinrichtung 71 ist auf eine Grundplatte 72 befestigt, worauf eine untere fest fixierte Platte 74 und eine obere bewegliche Platte 76 angeordnet sind. Der Schaltungsträger 28 ist unmittelbar auf der beweglichen Platte 76 positioniert, welche in Heberichtung 78 heb- und senkbar sowie in Verschiebungsrichtungen 80,82 schwenkbar ist.

Des weiteren ist auf der Grundplatte 74 eine für die Kontakteinrichtungen 4,6 vorgesehene Trageinrichtung 84 mit auf Stützen 86 gelagerten Längsbalken 88 angeordnet. Die Längsbalken 88 tragen Querbalken 90, woran die Kontakteinrichtungen 4,6 über Halteblöcke 92 fixiert sind. Dabei sind die Halteblöcke 92 in Heberichtung 78 heb- und senkbar an den Querbalken 90 ausgebildet, um Endspitzen der in Fig. 2 durch Pfeile angedeuteten Prüfnadeln auf die Prüfstellen 44,46 des auf der beweglichen Platte 76 gelagerten Schaltungsträgers 28 herab zu senken. Die Signal- und Masseplättchen sind in Fig. 2 nicht detailliert dargestellt und nicht mit Bezugszeichen versehen. Ferner sind die Kontakteinrichtungen 4,6 über die beispielsweise als Koaxkabel ausgebildeten Signalleitungen 24,26 an den Netzwerkanalysator 2 angeschlossen.

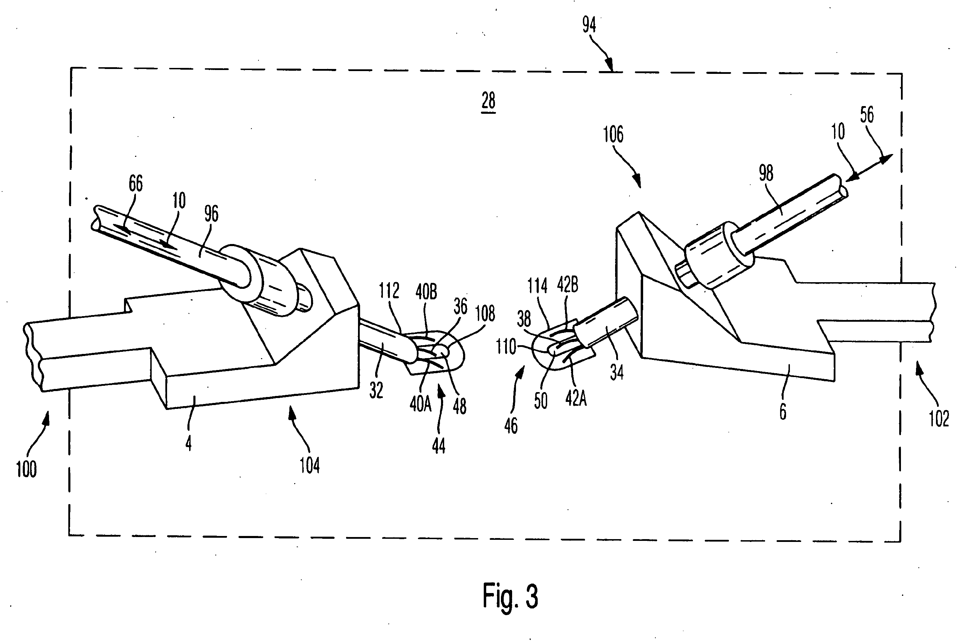

Fig. 3 zeigt einen Ausschnitt 94 des Schaltungsträgers 28 mit den Kontakteinrichtungen 4,6 mit Anschlussstücken 96,98 der beispielsweise als Koaxialkabel ausgebildeten Signalleitungen 24,26, worüber das Anregungssignal 10 anhand der Prüfnadeln 36,38,40A,40B,42A,42B an den Prüfstellen 44,46 einspeisbar und das rücklaufende Messsignal 56,66 ausspeisbar sind. Die Kontakteinrichtungen 4,6 sind über deren Heckteile 100,102 an den in Fig. 2 gezeigten Halteblöcken 92 gehalten. Die die Prüfnadeln 36,38,40A,40B,42A,42B tragenden Messspitzen 32,34 sind an Frontteilen 104,106 der Kontakteinrichtungen 4,6 angeordnet.

Im in Fig. 3 gezeigten Ausführungsbeispiel trägt jede Messspitze 32,34 eine Signalprüfnadel 36,38 sowie jeweils zwei zu der Signalprüfnadel 36,38 beabstandete und zu dieser elektrisch isoliert angeordnete Masseprüfnadeln 40A,40B,42A,42B. Die Prüfnadeln 36,38,40A,40B,42A,42B kontaktieren mit Endspitzen die am Schaltungsträger 28 vorgesehenen Prüfstellen 44,46. Dabei sind die Prüfstellen 44,46 im in Fig. 3 gezeigten Ausführungsbeispiel hufeisenförmig am Schaltungsträger 28 ausgebildet. Inmitten der Prüfstelle 44,46 ist das Signalplättchen 48,50 ausgebildet, welches mit der in Fig. 3 der Einfachheit halber nicht dargestellten Hochfrequenzstruktur 30 (Fig. 2) signalverbindbar ist. Das Signalplättchen 48,50 ist von dem Masseplättchen 52,54 durch einen dielektrischen Leerstreifen 108, 110 elektrisch isoliert. Ferner ist auch das Masseplättchen 52,54 in Bezug auf eine in Fig. 3 nicht dargestellte, die Prüfstelle 44,46 umgebende Schaltungsstruktur durch Leerstreifen 112,114 elektrisch isoliert angeordnet.

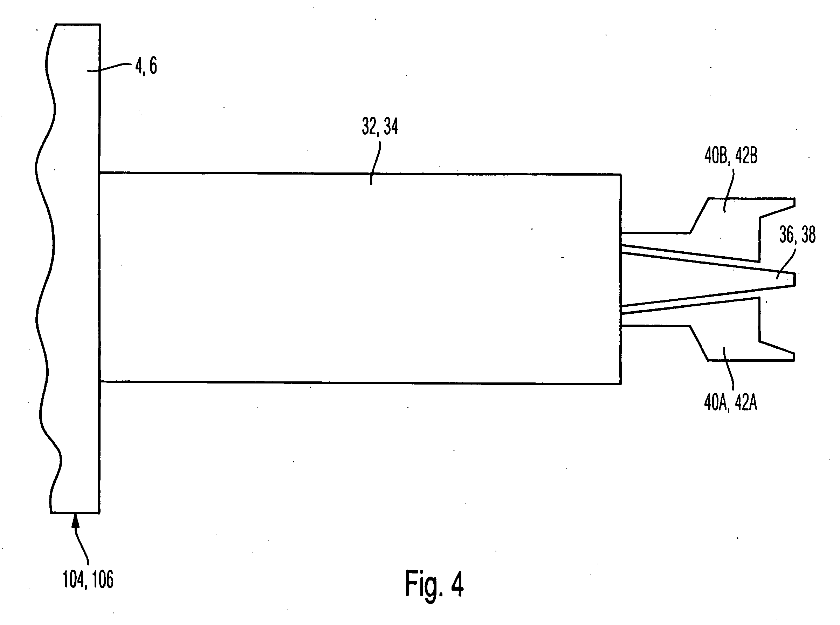

In Fig. 4 ist die Messspitze 32,34 detailliert gezeigt, welche am Frontteil 104, 106 der Kontakteinrichtung 4,6 angeordnet ist und eine Signalprüfnadel 36,38 sowie zwei zur Signalprüfnadel 36,38 beabstandete und zu dieser elektrisch isoliert angeordnete Masseprüfnadeln 40A,40B,42A,42B trägt. Dabei ist die in Fig. 4 gezeigte Signalprüfnadel 36,38 zwischen den zwei Masseprüfnadeln 40A,40B,42A,42B angeordnet.

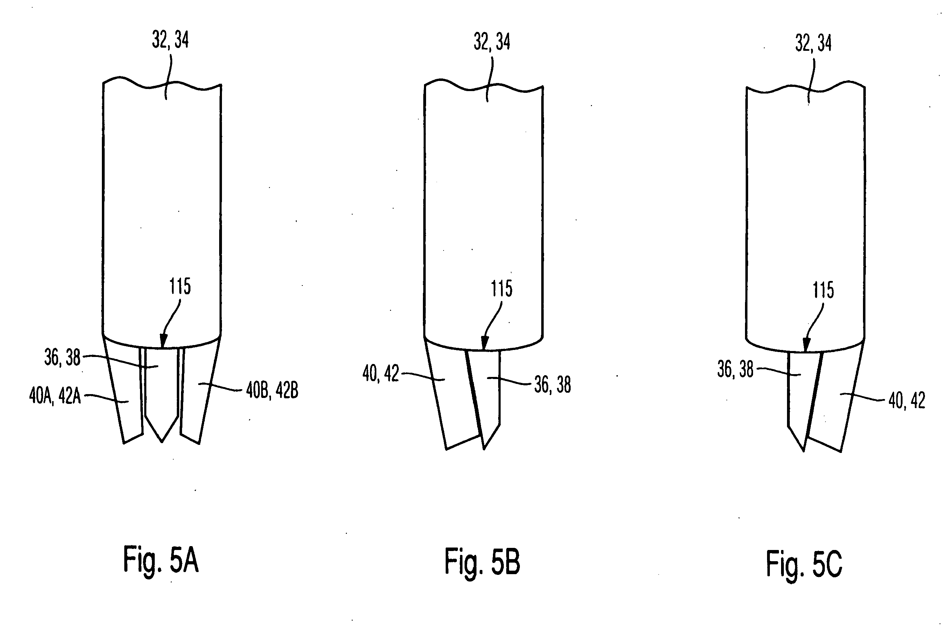

In Figuren 5A, 5B, 5C ist die Messspitze 32,34 mit an dieser angeordneten Prüfnadeln 36,38,40,42,40A,40B,42A,42B in unterschiedlichen Anordnungsvarianten und mit unterschiedlicher Anzahl an Prüfnadeln gezeigt. In Fig. 5A sind die Prüfnadeln 36,38,40A,40B,42A,42B an der Messspitze 32,34 in der gleichen Art und Weise wie in Fig. 4 angeordnet. Die Prüfnadeln 36,38,40A,40B,42A,42B sind nach dem Schema Masse-Signal-Masse an einem dafür vorgesehenen Anschlussende 115 der Messspitze 32,34 an dieser fixiert. In Fig. 5B ist eine Signalprüfnadel 36,38 und eine Masseprüfnadel 40,42 nach dem Schema Masse-Signal linksbündig am Anschlussende 115 der Messspitze 32,34 befestigt. Im Gegensatz dazu ist die Anordnung der Prüfnadeln 36,38,40,42 in Fig. 5C umgekehrt. Die Prüfnadeln sind dabei rechtsbündig am Anschlussende 115 der Messspitze 32,34 befestigt.

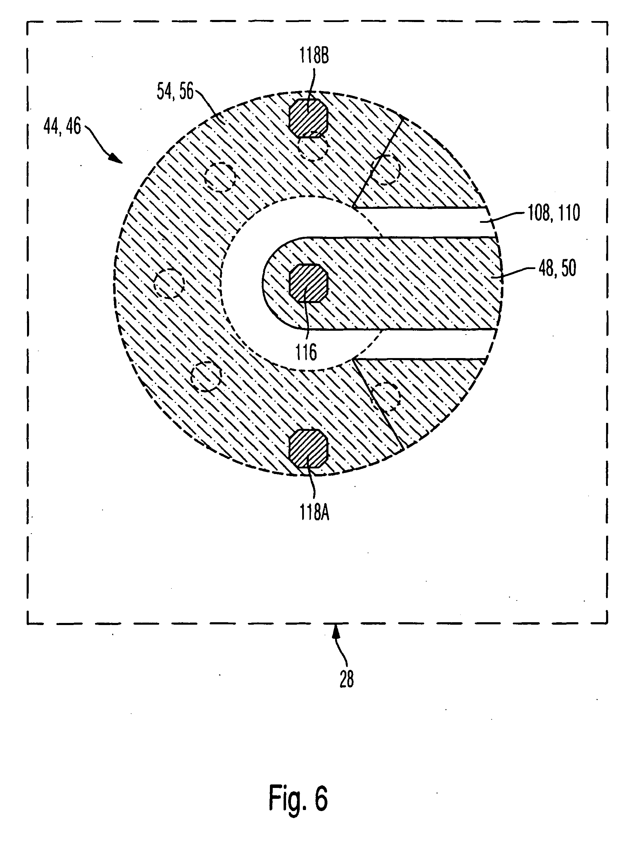

Fig. 6 zeigt die Prüfstelle 44,46 gemäß Fig. 3 im Detail. Die Prüfstelle 44,46 ist auf einer Oberfläche des Schaltungsträgers 28 angeordnet und weist das im Ausführungsbeispiel gemäß Fig. 6 hufeisenförmig ausgebildete Masseplättchen 54,56 sowie das Signalplättchen 48,50 auf, welches mit der in Fig. 6 nicht dargestellten Hochfrequenzstruktur 30 signalverbindbar ist. Dabei ist das Signalplättchen 48,50 von dem Masseplättchen 54,56 durch den hufeisenförmigen, dielektrischen Leerstreifen 108,110 elektrisch isoliert angeordnet, welcher im Ausführungsbeispiel gemäß Fig. 6 Bestandteil des mit einer gestrichelten Linie angedeuteten Schaltungsträgers 28 ist.

Die in Fig. 6 gezeigte Prüfstelle 44,46 ist besonders für die in Fig. 5A gezeigte Messspitze 32, 34 mit einer Signalprüfnadel 36,38 sowie zwei Masseprüfnadeln 40A,40B,42A,42B geeignet ausgebildet. In Fig. 6 sind weiter als Achtecke dargestellte Kontaktflächen 116,118A,118B gezeigt, welche Bestandteil der Prüfstelle 44,46 sind, womit die Endspitzen der Prüfnadeln 36,38,40A,40B,42A,42B in Kontakt treten. Zweckmäßigerweise sind die Kontaktflächen 116,11BA,118B derart zueinander beabstandet, dass der Abstand deren Mittelpunkte jeweils etwa 1000µm beträgt.

Die Erfindung ist nicht auf die dargestellten Ausführungsbeispiele beschränkt und ist insbesondere auch bei anders als in der Zeichnung ausgestalteten Schaltungsträgern sowie Prüfsystemen, insbesondere bei einem Prüfsystem mit einer einzelnen Kontakteinrichtung oder mehr als zwei Kontakteinrichtungen für n-Tor-Messobjekte, geeignet.

Die vorliegende Erfindung eignet sich insbesondere auch für differenzielle Messungen mit differenziellen Prüfsignalen. Dabei wird an zwei Toren des Netzwerkanalysators jeweils ein Signal mit 180° Phasenverschiebung (differential mode) erzeugt und in die Hochfrequenzstruktur eingespeist. Das Messsignal wird ebenfalls differenziell ausgespeist, d.h. es stehen ausgangsseitig wiederum zwei Messtore des Netzwerkanalysators zur Verfügung und es wird insbesondere die Einhaltung der Phasendifferenz von 180° durch die zur vermessende Hochfrequenzstruktur überprüft. Die differenzielle Messung hat den Vorteil, dass sie gegenüber umgebungsbedingten Gleichtaktstörungen, die beispielsweise durch das elektrische Versorgungsnetz aber auch durch andere Störquellen verursacht werden können, unempfindlich ist. Außerdem werden heute Hochfrequenzstrukturen zunehmend mit differenzieller Leitungsführung aufgebaut.

Alle vorstehend beschriebenen und in der Zeichnung dargestellten Merkmale sind beliebig miteinander kombinierbar.

## Patentansprüche

1. Prüfsystem (1) zur Analyse eines mit einer Hochfrequenzstruktur (30) bestückten Schaltungsträgers (28) mit
einem Netzwerkanalysator (2) umfassend einen Signalgenerator (8) zur Erzeugung eines über eine Signalleitung (12,20,22,24,26) der Hochfrequenzstruktur (30) zuführbaren Anregungssignals (10) und eine Auswerteeinrichtung (58) zur Analyse eines von der Hochfrequenzstruktur (30) rücklaufenden Messsignals (56,66), und
einer an die Signalleitung (24,26) anschließbaren Kontakteinrichtung (4,6) zur Einspeisung des Anregungssignals (10) in die Hochfrequenzstruktur (30) und zur Ausspeisung des Messsignals (56,66),
**dadurch gekennzeichnet,**
**dass** die Hochfrequenzstruktur (30) für eine störfreie Analyse durch mindestens einen überbrückbaren Leerstreifen (70) von einer umliegenden, am Schaltungsträger (28) angeordneten Schaltungsstruktur (69) isolierbar ist.

2. Prüfsystem nach Anspruch 1,
**dadurch gekennzeichnet,**
**dass** die Kontakteinrichtung (4,6) eine Messspitze (32,34) zur Aufnahme von Prüfnadeln (36,38,40,42) umfasst, womit eine am Schaltungsträger (28) angeordnete und mit der Hochfrequenzstruktur (30) signalverbindbare Prüfstelle (44,46) kontaktierbar ist.

3. Prüfsystem nach Anspruch 1 oder 2,
**dadurch gekennzeichnet,**
**dass** die Hochfrequenzstruktur (30) an einem Nutzenrand des Schaltungsträgers (28) vorgesehen ist.

4. Prüfsystem nach einem der Ansprüche 1 bis 3,
**gekennzeichnet durch**
eine Halte- und Positioniereinrichtung (71) zum Halten und Ausrichten des Schaltungsträgers (28) und der Kontakteinrichtung (4,6).

5. Prüfsystem nach Anspruch 2,
**dadurch gekennzeichnet,**
**dass** die Messspitze (32,34) eine Signalprüfnadel (36,38) zur Kontaktierung eines an der Prüfstelle (44,46) vorgesehenen Signalplättchens (48,50) und zumindest eine Masseprüfnadel (40,42) zur Kontaktierung eines zum Signalplättchen (48,50) beabstandeten, zu diesem elektrisch isoliert angeordneten und an der Prüfstelle (44,46) vorgesehenen Masseplättchens (52,54) aufweist.

6. Prüfsystem nach Anspruch 5,
**dadurch gekennzeichnet,**
**dass** zwischen einer am Signalplättchen (48,50) angeordneten Kontaktfläche (116) und einer am Masseplättchen (52,54) angeordneten Kontaktfläche (118A,118B) ein Abstand von etwa 500µm bis 1500µm vorgesehen ist.

7. Prüfsystem nach einem der Ansprüche 2, 5 oder 6,
**dadurch gekennzeichnet,**
**dass** die Prüfnadel (36,38,40,42) zumindest teilweise von einer Schutzummantelung umgeben ist.

8. Prüfsystem nach einem der Ansprüche 2 oder 5 bis 7,
**gekennzeichnet durch**
für die Prüfnadeln (36,38,40,42) vorgesehene Kalibrierstrukturen.

9. Prüfsystem nach einem der. Ansprüche 1 bis 8,
**dadurch gekennzeichnet,**
**dass** der Schaltungsträger (28) aus einem dielektrischen und für Hochfrequenzanwendungen geeigneten Material, insbesondere Polytetrafluorethylen, Polyimid und/oder aus einer Glas- und Keramiklegierung, ausgebildet ist.

10. Prüfsystem nach einem der Ansprüche 1 bis 9,
**dadurch gekennzeichnet,**
**dass** der Schaltungsträger (28) mehrschichtig ausgeführt ist.

11. Prüfsystem nach einem der Ansprüche 1 bis 10,
**dadurch gekennzeichnet,**
**dass** der Schaltungsträger (28) zur Bestückung mit bedrahteten Bauelementen ausgebildet ist.

12. Prüfsystem nach einem der Ansprüche 1 bis 11,
**dadurch gekennzeichnet,**
**dass** der Schaltungsträger (28) zur Bestückung mit oberflächenmontierbaren SMD-Bauelementen ausgebildet ist.

13. Prüfsystem nach einem der Ansprüche 1 bis 12,
**dadurch gekennzeichnet,**
**dass** der das Anregungssignal (10) erzeugende Signalgenerator (8) zum Durchfahren eines vorgebbaren Frequenzbereiches des Anregungssignals (10) ausgebildet ist.

14. Prüfsystem nach einem der Ansprüche 1 bis 13,
**dadurch gekennzeichnet,**
**dass** das Anregungssignal (10) zur Analyse des Messsignals (56,66) am Netzwerkanalysator (2) als Referenzsignal (62) auskoppelbar ist.

## Claims

1. Testing system (1) for analysing a circuit carrier (28) fitted with a high-frequency structure (30) with
a network analyser (2) comprising a signal generator (8) for the generation of an excitation signal (10) capable of being supplied via a signal line (12, 20, 22, 24, 26) to the high-frequency structure (30) and an evaluation device (58) for the analysis of a test signal (56, 66) returning from the high-frequency structure (30), and a contacting device (4, 6) capable of being connected to the signal line (24, 26) for the supply of the excitation signal (10) to the high-frequency structure (30) and for the output of the test signal (56, 66),
**characterised in that,**
for an noise-free analysis, the high-frequency structure (30) can be isolated from the surrounding circuit structure (69) disposed on the circuit carrier (28) by at least one bridgeable blank strip (70).

2. Testing system according to claim 1,
**characterised in that**
the contacting device (4, 6) comprises a test probe (32, 34) for the accommodation of test needles (36, 38, 40, 42), with which a testing point (44, 46) disposed on the circuit carrier (28) and signal-connectable to the high-frequency structure (30) is contactable.

3. Testing system according to claim 1 or 2,
**characterised in that**
the high-frequency structure (30) is provided on a panel edge of the circuit carrier (28).

4. Testing system according to any one of claims 1 to 3,
**characterised by**
a holding and positioning device (71) for holding and aligning the circuit carrier (28) and the contacting device (4, 6).

5. Testing system according to claim 2,
**characterised in that**
the test probe (32, 34) provides a signal-test needle (36, 38) for contacting a signal plate (48, 50) provided on the testing point (44, 46) and at least one earth-test needle (40, 42) for contacting an earth plate (52, 54) disposed at a spacing distance from the signal plate (48, 50), electrically isolated from the latter and provided at the testing point (44, 46).

6. Testing system according to claim 5,
**characterised in that,**
between a contact surface (116) disposed on the signal plate (48, 50) and a contact surface (118A, 118B) disposed on the earth plate (52, 54), a spacing distance of approximately 500 µm to 1500 µm is provided.

7. Testing system according to any one of claims 2, 5 or 6,
**characterised in that**
the test needle (36, 38, 40, 42) is at least partially surrounded by a protective casing.

8. Testing system according to any one of claims 2 or 5 to 7,
**characterised by**
calibration structures provided for the test needles (36, 38, 40, 42).

9. Testing system according to any one of claims 1 to 8,
**characterised in that**
the circuit carrier (28) is formed from a dielectric material suitable for high-frequency applications, especially polytetrafluoroethylene, polyimide and/or from a glass-ceramic alloy.

10. Testing system according to any one of claims 1 to 9,
**characterised in that**
the circuit carrier (28) is designed in a multilayered manner.

11. Testing system according to any one of claims 1 to 10,
**characterised in that**
the circuit carrier (28) is designed for fitting with wired components.

12. Testing system according to any one of claims 1 to 11,
**characterised in that**
the circuit carrier (28) is designed for fitting with surface-mountable SMD components.

13. Testing system according to any one of claims 1 to 12,
**characterised in that**
the signal generator (8) generating the excitation signal (10) is designed for the passage of a specifiable frequency range of the excitation signal (10).

14. Testing system according to any one of claims 1 to 13,
**characterised in that**
the excitation signal (10) can be de-coupled as a reference signal (62) for the analysis of the test signal (56, 66) in the network analyser (2).

## Revendications

1. Système de test ou de contrôle (1) pour l'analyse d'un support de circuit (28) équipé d'une structure haute fréquence (30), comprenant
un analyseur de réseau (2) englobant un générateur de signal (8) pour produire un signal d'excitation (10) pouvant être transmis à la structure haute fréquence (30) par l'intermédiaire d'une ligne de transmission de signal (12, 20, 22, 24, 26), et un dispositif de traitement (58) pour l'analyse d'un signal de mesure (56, 66) fourni en retour par la structure haute fréquence (30), et
un dispositif de contact (4, 6) pouvant être raccordé à la ligne de transmission de signal (24, 26) et destiné à alimenter la structure haute fréquence (30) avec le signal d'excitation (10), et à fournir en sortie le signal de mesure (56, 66),
**caractérisé**
**en ce que** la structure haute fréquence (30), en vue d'une analyse exempte de parasites et de perturbations, peut être isolée d'une structure de circuit environnante (69) agencée sur le support de circuit (28), par au moins une bande vide (70) susceptible d'être pontée.

2. Système de contrôle selon la revendication 1,
**caractérisé**
**en ce que** le dispositif de contact (4, 6) comprend un pointeau de mesure (32, 34) destiné à recevoir des stylets de contrôle ou de test (36, 38, 40, 42), à l'aide desquels il est possible d'établir le contact avec une zone de contrôle (44, 46) qui est agencée sur le support de circuit (28) et peut être reliée, sur le plan de la transmission de signal, avec la structure haute fréquence (30).

3. Système de contrôle selon la revendication 1 ou 2,
**caractérisé**
**en ce que** la structure haute fréquence (30) est prévue au niveau d'un bord de carte ou de flan du support de circuit (28).

4. Système de contrôle selon l'une des revendications 1 à 3,
**caractérisé**
**par** un dispositif de maintien et de positionnement (71) pour maintenir et orienter le support de circuit (28) et le dispositif de contact (4, 6).

5. Système de contrôle selon la revendication 2,
**caractérisé**
**en ce que** le pointeau de mesure (32, 34) comprend un stylet de contrôle de signal (36, 38) pour venir contacter une pastille de signal (48, 50) prévue au niveau de la zone de contrôle (44, 46), et au moins un stylet de contrôle de masse (40, 42) destiné à venir contacter une pastille de masse (52, 54), qui est espacée de la pastille de signal (48, 50), est agencée de manière électriquement isolée de celle-ci, et est prévue au niveau de la zone de contrôle (44, 46).

6. Système de contrôle selon la revendication 5,
**caractérisé**
**en ce qu'**entre une surface de contact (116) agencée sur la pastille de signal (48, 50) et une surface de contact (118A, 118B) agencée sur la pastille de masse (52, 54) est prévue une distance d'espacement d'environ 500 µm à 1500 µm.

7. Système de contrôle selon l'une des revendications 2, 5 ou 6,
**caractérisé**
**en ce que** le stylet de contrôle (36, 38, 40, 42) est entouré au moins partiellement par une enveloppe de protection.

8. Système de contrôle selon l'une des revendications 2 ou 5 à 7,
**caractérisé**
**par** des structures de calibrage prévues pour les stylets de contrôle (36, 38, 40, 42).

9. Système de contrôle selon l'une des revendications 1 à 8,
**caractérisé**
**en ce que** le support de circuit (28) est réalisé en un matériau diélectrique et adapté à des utilisations haute fréquence, en particulier du polytétrafluoroéthylène, un polyimide et/ou en un alliage de verre et céramique.

10. Système de contrôle selon l'une des revendications 1 à 9,
**caractérisé**
**en ce que** le support de circuit (28) est d'une configuration à couches multiples.

11. Système de contrôle selon l'une des revendications 1 à 10,
**caractérisé**
**en ce que** le support de circuit (28) est conçu pour être équipé de composants câblés.

12. Système de contrôle selon l'une des revendications 1 à 11,
**caractérisé**
**en ce que** le support de circuit (28) est conçu pour être équipé de composants SMD pour montage en surface.

13. Système de contrôle selon l'une des revendications 1 à 12,
**caractérisé**
**en ce que** le générateur de signal (8) produisant le signal d'excitation (10) est conçu pour balayer une plage de fréquence prédéterminée du signal d'excitation (10).

14. Système de contrôle selon l'une des revendications 1 à 13,
**caractérisé**
**en ce que** le signal d'excitation (10) peut être découplé dans l'analyseur de réseau (2) en tant que signal de référence (62) pour l'analyse du signal de mesure (56, 66).
